(19) Europäisches Patentamt
European Patent Office
Office européen des brevets

(11) **EP 2 347 895 A1**

(12) **EUROPEAN PATENT APPLICATION**
published in accordance with Art. 153(4) EPC

(43) Date of publication:
**27.07.2011 Bulletin 2011/30**

(51) Int Cl.:
*B32B 9/00* (2006.01)  *B32B 7/02* (2006.01)
*B32B 15/04* (2006.01)  *G09F 9/00* (2006.01)
*H05K 9/00* (2006.01)

(21) Application number: **09826080.5**

(22) Date of filing: **10.11.2009**

(86) International application number:
**PCT/JP2009/069131**

(87) International publication number:
**WO 2010/055832 (20.05.2010 Gazette 2010/20)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **11.11.2008 JP 2008288891**

(71) Applicant: **Asahi Glass Company Limited**
**Chiyoda-ku**
**Tokyo 100-8405 (JP)**

(72) Inventors:
• **KAWAMOTO, Yasushi**
**Tokyo 100-8405 (JP)**
• **SHIDOJI, Eiji**
**Tokyo 100-8405 (JP)**
• **MAESHIGE, Kazunobu**
**Tokyo 100-8405 (JP)**
• **MASHIMO, Takahiro**
**Tokyo 100-8405 (JP)**

(74) Representative: **Müller-Boré & Partner**
**Patentanwälte**
**Grafinger Straße 2**
**81671 München (DE)**

(54) **ELECTRICALLY CONDUCTIVE LAMINATE, AND PROTECTIVE PLATE FOR PLASMA DISPLAY**

(57)    To provide an electroconductive laminate which has an excellent electrical conductivity (electromagnetic wave shielding properties) and a high visible light transmittance and is excellent in productivity, and a protective plate for a plasma display which has excellent electromagnetic wave shielding properties and a broad transmission/reflection band and is excellent in productivity.

An electroconductive laminate comprising a substrate and an electroconductive film formed on the substrate, wherein the electroconductive film has laminated n lamination units (wherein n is an integer of from 1 to 6) each having a first metal oxide layer, a second metal oxide layer and a metal layer arranged in this order from the substrate side, and further has a first metal oxide layer disposed as the outermost layer of the electroconductive film; the first metal oxide layer is an oxide layer containing titanium element and an M element, wherein the M element is at least one element selected from the group consisting of elements having atomic weights of at least 80, and the amount of the M element is from 10 to 60 atom% in the total amount of titanium element and the M element in the first metal oxide layer; the second metal oxide layer is a layer having, as its main component, an oxide containing zinc element; the metal layer is a layer having silver as its main component; and the second metal oxide layer and the metal layer in the lamination unit are directly in contact with each other.

F i g. 1

**Description**

TECHNICAL FIELD

The present invention relates to an electroconductive laminate and a protective plate for a plasma display.

BACKGROUND ART

Electroconductive laminates having transparency are used as a transparent electrode of e.g. liquid crystal display devices, a windshield glass for automobiles, a heat mirror (heat reflective glass), an electromagnetic wave shielding window glass, an electromagnetic wave shielding filter for a plasma display panel (hereinafter referred to as PDP), and so on.

As such electroconductive laminates, the following ones are proposed:

(1) An electromagnetic wave shielding laminate having an electroconductive film on a transparent substrate, which electroconductive film has an oxide layer composed of titanium oxide, a layer containing zinc oxide as the main component and a metal layer composed of a rare metal such as silver, repeatedly laminated in order (Patent Documents 1 and 2);

(2) An electromagnetic wave shielding film having a layer of titanium oxide containing niobium element in an amount of from 0.63 to 6.3 atom% in the total of titanium and niobium for the purpose of imparting electrical conductivity, and a layer of silver, repeatedly laminated on a transparent substrate (Patent Document 3).

In the case of the electroconductive laminate (1), it uses titanium oxide, which is a material having a high refractive index, as the oxide layer, and thereby can maintain a high visible light transmittance even when the thickness of the metal layer is made thick to some extent. However, when, for example, such an electroconductive laminate is used for a PDP filter, the value of electrical resistance cannot be made sufficiently low while the visible light transmitting properties are satisfied, and the electromagnetic wave shielding properties are insufficient in some cases.

In the case of the electromagnetic wave shielding film (2), the purpose of adding niobium oxide is to impart electrical conductivity, and thus niobium oxide is contained only in a slight amount (1.9 atom% in the specific embodiments), and the value of electrical resistance cannot be made sufficiently low while the visible light transmitting properties are satisfied, either.

Further, in a case of forming a titanium oxide layer by sputtering using a target containing titanium oxide as the main component, there has been a problem that the sputtering rate is slow.

On the other hand, a multilayer film having a dielectric layer having a high refractive index, which contains titanium oxide and at least 30 atom% of another metal component in the entire metal, and a dielectric layer having a low refractive index alternately laminated is known (Patent Document 4). However, there is no description about a combination of a titanium oxide layer and a metal layer in Patent Document 4.

PRIOR ART DOCUMENTS

PATENT DOCUMENTS

Patent Document 1: WO2005/20655
Patent Document 2: JP 2000-246831 A
Patent Document 3: JP 2000-294980 A
Patent Document 4: JP 2002-277630 A

DISCLOSURE OF INVENTION

TECHNICAL PROBLEM

The present invention is to provide an electroconductive laminate which has an excellent electrical conductivity (electromagnetic wave shielding properties) and a high visible light transmittance and is excellent in productivity at the time of production, and a protective plate for a plasma display which has excellent electromagnetic wave shielding properties and a broad transmission/reflection band and is excellent in improvement of productivity.

SOLUTION TO PROBLEM

The present invention provides an electroconductive laminate comprising a substrate and an electroconductive film formed on the substrate, wherein the electroconductive film has laminated n lamination units (wherein n is an integer of from 1 to 6) each having a first metal oxide layer, a second metal oxide layer and a metal layer arranged in this order from the substrate side, and further has a first metal oxide layer disposed as the outermost layer of the electroconductive film; the first metal oxide layer is an oxide layer containing titanium element and an M element, wherein the M element is at least one element selected from the group consisting of elements having atomic weights of at least 80, and the amount of the M element is from 10 to 60 atom% in the total amount of titanium element and the M element in the first metal oxide layer; the second metal oxide layer is a layer having, as its main component, an oxide containing zinc element; the metal layer is a layer having silver as its main component; and the second metal oxide layer and the metal layer in the lamination unit are directly in contact with each other.

The present invention provides an electroconductive laminate comprising a substrate and an electroconductive film formed on the substrate, wherein the electroconductive film has laminated n lamination units (wherein n is an integer of from 1 to 6) each having a first metal oxide layer, a second metal oxide layer and a metal layer arranged in this order from the substrate side, and further has a first metal oxide layer disposed as the outermost layer of the electroconductive film; the first metal oxide layer is an oxide layer containing titanium element and an M element, wherein the M element is niobium element, tantalum element, zirconium element or hafnium element, and the amount of the M element is from 10 to 60 atom% in the total amount of titanium element and the M element in the first metal oxide layer; the second metal oxide layer is a layer having, as its main component, an oxide containing zinc element; the metal layer is a layer having silver as its main component; and the second metal oxide layer and the metal layer in the lamination unit are directly in contact with each other.

Also, the present invention provides a process for producing an electroconductive laminate, which comprises repeating the following steps (1) to (3) n times (wherein n is an integer of from 1 to 6); and then forming a first metal oxide layer as the outermost layer by carrying out the following step (1):

(1) a step of forming a first metal oxide layer on one surface of a substrate by a sputtering method using a target containing titanium element and an M element (wherein the M element is at least one element selected from the group consisting of elements having atomic weights of at least 80);
(2) a step of forming a second metal oxide layer by a sputtering method using a target containing zinc element;
(3) a step of forming a metal layer by a sputtering method using a target containing silver as its main component.

Further, the present invention provides a process for producing an electroconductive laminate, which comprises repeating the following steps (1) to (4) n times (wherein n is an integer of from 1 to 6); and then forming a first metal oxide layer as the outermost layer by carrying out the following step (1):

(1) a step of forming a first metal oxide layer on one surface of a substrate by a sputtering method using a target containing titanium element and an M element (wherein the M element is at least one element selected from the group consisting of elements having atomic weights of at least 80);
(2) a step of forming a second metal oxide layer by a sputtering method using a target containing zinc element;
(3) a step of forming a metal layer by a sputtering method using a target containing silver as its main component;
(4) a step of forming a third metal oxide layer by a sputtering method using a target containing zinc element.

ADVANTAGEOUS EFFECTS OF INVENTION

According to the present invention, an electroconductive laminate which has an excellent electrical conductivity (electromagnetic wave shielding properties) and a high visible light transmittance and is excellent in productivity can be obtained, and by using such an electroconductive laminate, a protective plate for a plasma display which has excellent electromagnetic wave shielding properties and a broad transmission/reflection band and is excellent in productivity can be provided. Further, such an electroconductive laminate is useful as an electromagnetic wave shielding film for a plasma display, a transparent electrode of liquid crystal display devices, and so on.

BRIEF DESCRIPTION OF DRAWINGS

Fig. 1 is a cross-sectional view illustrating an example of the electroconductive laminate of the present invention.
Fig. 2 is a cross-sectional view illustrating another example of the electroconductive laminate of the present invention.

Fig. 3 is a cross-sectional view illustrating the first embodiment of the protective plate for a plasma display of the present invention.

Fig. 4 is a cross-sectional view illustrating the electroconductive laminate produced in Example 9 (comparative example) in the present description.

Fig. 5 is a chart showing spectral reflectivity of the electroconductive laminates produced in Example 8 (working example) and Example 9 (comparative example) in the present description.

DESCRIPTION OF EMBODIMENTS

<Electroconductive Laminate>

The electroconductive laminate of the present invention will be described below with reference to Figures, but the present invention is not limited to these Figures.

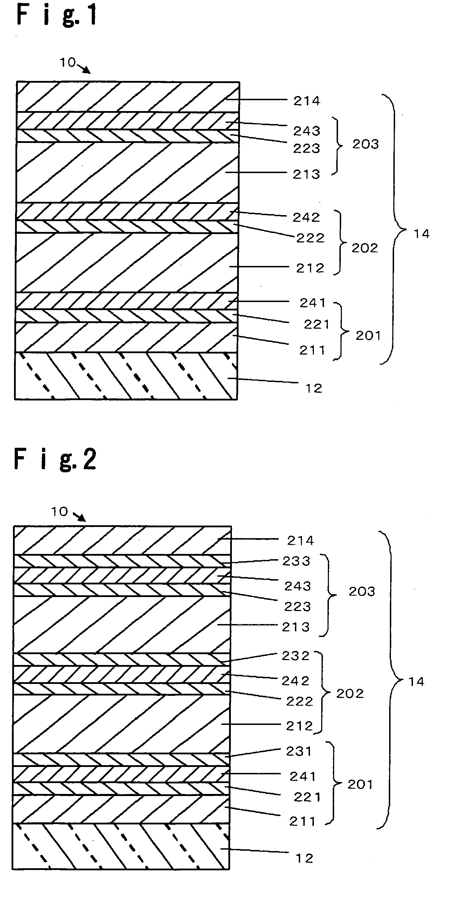

Fig. 1 is a cross-sectional view illustrating an example of the electroconductive laminate of the present invention, i.e. an example of an electroconductive film wherein n=3. An electroconductive laminated 10 has a substrate 12 and an electroconductive film 14.

(Substrate)

As the substrate 12, a transparent substrate is preferred. Transparent means transmitting light having a wavelength within a visible light region.

The material for the transparent substrate may, for example, be glass (including tempered glass such as air-cooled tempered glass or chemically tempered glass) or a plastic such as polyethylene terephthalate (PET), triacetyl cellulose (TAC), polycarbonate (PC) or polymethyl methacrylate (PMMA).

The thickness of the transparent substrate made of glass is preferably from 0.1 to 15 mm, more preferably from 1.0 to 2.3 mm, particularly preferably from 1.6 to 2 mm.

The thickness of the transparent substrate made of a plastic is preferably from 1 to 500 $\mu$m, more preferably from 10 to 200 $\mu$m, particularly preferably from 40 to 110 $\mu$m.

(Electroconductive Film)

The electroconductive film 14 in the present invention has n-time laminated a lamination unit 201 (wherein n is an integer of from 1 to 6) having a first metal oxide layer 211, a second metal oxide layer 221 and a metal layer 241 arranged in this order from the side of the substrate 12. In the case of Fig. 1, n is 3, and a first oxide layer 214 is further disposed on a third lamination unit 203.

n is preferably from 2 to 5, more preferably from 2 to 4. When n is at least 2, the electrical conductivity (electromagnetic wave shielding properties) is excellent. When n is at most 6, it is possible to suppress an increase in the internal stress of electroconductive film 14.

(First Metal Oxide Layer)

The first metal oxide layer in the present invention is an oxide layer containing titanium element and an M element. The M element is at least one element selected from the group consisting of elements having atomic weights of at least 80. The atomic weights of the M element is preferably from 85 to 200, more preferably from 90 to 190. It is considered that the first metal oxide layer is an oxide layer containing titanium element and an M element, whereby the first metal oxide layer has its crystal structure collapsed to be amorphous. As a result, the surface of the first metal oxide layer becomes flat and smooth. As a result, it is considered that the surface of the second metal oxide layer which will be described below also becomes smooth, and further, the surface of the metal layer also becomes smooth. And, it is presumed that if the surface of the metal layer becomes smooth, scattering of electrons at the surface of the metal layer becomes small, and thus the resistance value of the electroconductive laminated of the present invention can be made low.

Further, if the atomic weight of the M element is increased, the film forming rate by sputtering using a target having titanium element and an M element mixed can be increased, as compared with the case of film forming of an oxide layer only of titanium element. The upper limit of the atomic weight of the M element is preferably 200 from the viewpoint of availability. Further, the oxide only of the M element preferably has an refractive index of from 1.8 to 2.6, more preferably from 2.0 to 2.4. The oxide only of the M element preferably has a refractive index within the above range because the refractive index of the first metal oxide layer thereby can be high. Specifically, the M element is preferably, for example, at least one element selected from the group consisting of niobium element, tantalum element, zirconium element, hafnium element, strontium element, yttrium element and barium element. The M element is particularly preferably niobium element, tantalum element, zirconium element or hafnium element, from the viewpoint of availability of the material.

Among them, the M element is more preferably niobium element or zirconium element. As to niobium element and zirconium element, respective oxides only of them are likely to be densely amorphous. Therefore, it is considered that when the M element is niobium element or zirconium element, the first metal oxide layer as a whole also has the crystal properties largely collapsed, and the flatness of the surface will become better. Further, the M element is preferably niobium element or zirconium element, because in such a case, the refractive index of the first metal oxide layer is almost the same as the oxide layer only of titanium, and thus the optical properties of the electroconductive laminate of the present invention will be excellent. Particularly, in the case where the M element is zirconium element, when the first metal oxide layer is formed by sputtering, heat generation within the substrate at the time of sputtering is small, and thus it is possible to suppress change of shape and properties by heat of the substrate and the metal oxide layer and the metal layer already formed on the substrate. For example, as to a metal oxide layer already formed on a substrate, crystallization is likely to be promoted by heat. As a result, it is possible that surface roughness of the metal oxide layer is increased, and thus surface roughness of the second metal oxide layer and the metal layer are also increased, and the resistance value of the electroconductive laminate is increased. It is possible to suppress crystallization of the metal oxide layer and increase in resistance value of the electroconductive laminated by suppressing heat generation during sputtering. Further, when an already-formed layer undergoes thermal shrinkage or thermal expansion by heat, a stress remains in the layer in some cases. As a result, problems such as warpage of the electroconductive laminate and cracks on the electroconductive film may occur. It is possible to suppress such problems by suppressing heat generation.

It is presumed that the above heat generation within the substrate results from secondary electrons generated during sputtering. It is considered that heat generation within the substrate is smaller as the voltage of the secondary electrons is lower. Further, when the M element is zirconium element, the voltage of the secondary electron is low, and heat generation within the substrate can be suppressed. Further, heat generation within the substrate during sputtering can be suppressed to some extent by lowering the film forming rate, but there is a problem such that when the film forming rate is lowered, the productivity becomes worse. When the M element is zirconium element, the balance between the film forming rate by sputtering and temperature increase of the substrate during sputtering can be moderate, and therefore zirconium element is the most preferred material.

The temperature increase of the substrate at the time of forming of the first metal oxide layer is preferably at most 20°C, more preferably at most 15°C, further preferably at most 10°C. The lower limit of the temperature increase of the substrate is not particularly limited, but it is usually 1°C. The temperature increase of the substrate is set within the above temperature range, whereby there is an advantage that change in properties of a thin film already formed on the substrate can be prevented. Further, in the case where the substrate is made of a plastic, the temperature increase of the substrate is set within the above range, whereby change in shape of the substrate by heat can be suppressed, and thus such a temperature range is preferred.

In the case where the M element of the first metal oxide layer in the present invention is niobium element, it is considered that titanium element and niobium element present in the first metal oxide layer as any one or more of oxides only of respective metals such as $NbO$, $Nb_2O_5$, $TiO$ and $TiO_2$ or as a mixture such as titanium-niobium composite oxide. Further, in the case where the M element is zirconium element, it is considered that titanium element and zirconium element present in the first metal oxide layer as any one or more of oxides only of respective metals such as $ZrO_2$, $TiO$ and $TiO_2$ or as a mixture such as titanium-zirconium composite oxide.

The content of the M element in the total amount of titanium element and the M element in the first metal oxide layer is from 10 to 60 atom%, preferably from 13 to 50 atom%, further preferably from 14 to 30 atom%, most preferably from 15 to 25 atom%. When the content of the M element is at least 10 atom%, the structure of the first metal oxide layer becomes amorphous, and the first metal oxide layer can be a layer having a smooth surface having small surface roughness. Further, in the case where the first metal oxide layer is formed by sputtering using an oxide target of titanium element and the M element, the content of the M element is adjusted to be at least 10 atom%, whereby the film forming rate by sputtering can be increased. If the content is less than 10 atom%, such an effect cannot be obtained. Further, when the content is at most 60 atom%, a high refractive index of the first metal oxide layer can be maintained, and thus the refractive index of the laminate can be made high, and it is possible to bring the reflected color closer to neutral (achromatic color). The content of the M element in the first metal oxide layer may be measured by ESCA (X-ray photoelectron spectroscopy) or RBS (Rutherford Backscattering Spectroscopy).

The refractive index of the first metal oxide layer of the present invention depends on the ratio of titanium element to the M element or the refractive index of an oxide only of the M element. Specifically, the refractive index is preferably close to 2.45, which is the refractive index of titanium oxide, and is preferably from 2.0 to 2.6, more preferably from 2.2 to 2.5, further preferably from 2.3 to 2.5.

In the first metal oxide layer, substantially no metal element other than titanium element and the M element is contained. However, as an impurity, a small amount of another metal element may be contained. The content of such another metal element is preferably at most 5 atom%, more preferably at most 1 atom%, in the all metal elements of the first metal oxide layer. The content is at most 5 atom%, whereby optical properties of the electroconductive laminate of the present invention are good, and the resistance value can be made sufficiently low.

As to the thickness of the first metal oxide layers, in the case where n is from 2 to 6, the thickness of the first metal oxide layer which is the closest to the substrate and the thickness of the one which is the farthest from the substrate are preferably from 10 to 60 nm, more preferably from 15 to 40 nm. The thickness of the other first metal oxide layers is preferably from 10 to 120 nm, more preferably from 15 to 80 nm. When the thickness of the first metal oxide layer is within such a range, the flatness of the first metal oxide layer is good, and the resistance value of the metal layer can be made sufficiently low even when the thickness of the metal layer is thin, and therefore such a thickness of the first metal oxide layer is preferred. In the case of n=1, the thickness of the two first metal oxide layer is preferably 10 to 60 nm, more preferably from 15 to 40 nm.

The thickness of each layer is obtained by conversion from sputtering time for the film formation by using a calibration curve which is preliminarily prepared by the following method.

Preparation Method of Calibration Curve: On a surface of a substrate having its part covered with an ink of an oil-based pen, a film is formed by sputtering for any length of time. After film formation, the ink of an oil-based pen is removed. At the surface of the substrate, the difference in height between the portion where the ink of an oil-based pen has been removed and the portion where a film has been formed, is measured with a sensing pin-type surface roughness measuring instrument. The difference in height is the film thickness for the sputtering time. Then, the film thickness is measured in the same manner as the above except that the sputtering time for film formation is changed. The same measurement is repeated for at least 3 times, as the case requires. Based on the values obtained by the above measurement, a calibration curve relating to the sputtering time and the film thickness is prepared.

Each of the first metal oxide layers in the electroconductive laminate of the present invention may be in the same composition and of the same material, or may be in a different composition and of a different material. Further, also regarding to the film thickness, each of the first metal oxide layers may have the same one or a different one.

(Second Metal Oxide Layer)

The second metal oxide layer in the present invention is a layer having, as the main component, an oxide containing zinc oxide.

The layer having, as the main component, an oxide containing zinc element in the present invention preferably contains a metal element other than zinc element.

When a metal element other than zinc element is contained in the second metal oxide layer, it is considered that an oxide of zinc and a composite oxide of zinc and a metal other than zinc are present by mixture. Further, an oxide only of a metal other than zinc may be contained.

The metal other than zinc is preferably, for example, one or more metals selected from the group consisting of tin, aluminum, chromium, titanium, silicon, boron, magnesium and gallium, more preferably aluminum, gallium or titanium. That is, the second metal oxide layer is particularly preferably a layer containing, as the main component, a zinc oxide containing aluminum element (hereinafter referred to as AZO), a zinc oxide containing gallium element (hereinafter referred to as GZO) or a zinc oxide containing titanium element (hereinafter referred to as TZO). When the second metal oxide layer is an AZO layer, a GZO layer or a TZO layer, a stress in the layer can be made small, and thus it is possible to suppress separation with its adjoining metal layer at the boundary face.

In the case where the second metal oxide layer in the present invention is a TZO layer, the total content of Ti element and Zn element in the second metal oxide layer is preferably at least 90 atom%, more preferably at least 95 atom%, further preferably at least 99 atom%, in the all metal elements in the second metal oxide layer. In the case of a GZO layer or an AZO layer, in the same manner, the total amount of Ga element and Zn element or the total amount of Al element and Zn element is preferably at least 90 atom%, more preferably at least 95 atom%, further preferably at least 99 atom%, in the all metal elements in the second metal oxide layer. When the total amount of Zn element and Al element, Ga element or Ti element in the second metal oxide layer is within the above range, the adhesion to the adjoining metal layer is excellent and the moisture resistance is excellent.

The amount of aluminum element in AZO is preferably from 1 to 10 atom%, more preferably from 2 to 6 atom%, particularly preferably from 1.5 to 5.5 atom%, in the total amount of aluminum element and zinc element.

The amount of gallium element in GZO is preferably from 1 to 10 atom%, more preferably from 2 to 6 atom%, particularly preferably from 1.5 to 5.5 atom%, in the total amount of gallium element and zinc element.

The amount of titanium element in TZO is preferably from 2 to 20 atom%, more preferably from 3 to 15atom%, in the total amount of titanium element and zinc element.

When the amount of aluminum element, gallium element and titanium element are within the above ranges, the internal stress of the oxide layer can be reduced, and thus the possibility of formation of cracks can be made small, and further, the crystal structure of zinc oxide can be maintained.

The thickness of the second metal oxide layer is preferably from 1 to 60 nm, more preferably from 2 to 30 nm, further preferably from 2 to 15 nm. When the thickness of the second metal oxide layer is at least 1 nm, the adhesion to the metal layer is improved, and thus the specific resistance of the metal layer can be reduced by the foundation effect to the metal layer having silver as the main component. When it is at most 60 nm, the reflected color can be reduced. Therefore such a thickness is preferred.

(Metal Layer)

The metal layer in the present invention is a layer having silver as the main component. The layer having silver as the main component is preferably a layer made of pure silver or a layer made of a silver alloy. Further, a metal layer and a second metal oxide layer in a lamination unit in the present invention are directly in contact with each other. The metal layer and the second metal oxide layer are directly in contact with each other, whereby the crystal properties of silver of the metal layer improves, and the specific resistance of the metal layer is reduced.

The metal layer in the present invention is preferably a layer made of pure silver from the viewpoint of lowering the sheet resistance of the electroconductive laminate. Pure silver means that at least 99.9 atom% of silver is contained in the metal layer.

The metal layer in the present invention is preferably a film made of a silver alloy wherein at least one member selected from the group consisting of gold, bismuth and palladium is incorporated in silver from the viewpoint that migration of silver is suppressed so that the moisture resistance can be made high. The total amount of gold, bismuth and palladium in the metal layer is preferably from 0.05 to 5 atom%, more preferably from 0.1 to 3 atom%, particularly preferably from 0.1 to 1 atom%.

The total film thickness i.e. the total of the thickness of all the metal layers in the present invention is, in the case where, for example, the target of the sheet resistance of the electroconductive laminated is set to be 1.5 $\Omega/\square$, preferably from 15 to 70 nm, more preferably from 20 to 60 nm, particularly preferably from 30 to 50 nm; and in the case where the target of the sheet resistance is set to be 0.9 $\Omega/\square$, it is preferably from 20 to 80 nm, more preferably from 30 to 70 nm, particularly preferably from 40 to 60 nm. The total thickness is properly divided by the number of the metal layer i.e. n to obtain the thickness of each metal layer. When the number of the metal layers i.e. n becomes large, the thickness of each metal layer becomes thin, and thus the specific resistance of each metal layer is increased. Therefore, when the number of the metal layers i.e. n is large, the total film thickness tends to be large in order to reduce the resistance.

(Third Metal Oxide Layer)

The lamination unit of the electroconductive laminate of the present invention preferably further has a third metal oxide layer having, as the main component, an oxide containing zinc element on the surface of the metal layer at the side opposite to the substrate. The third metal oxide layer is preferably formed without using a large amount of an oxide gas at the time of film formation. The third metal oxide layer in the present invention is provided, whereby oxidation of the metal layer can be prevented at the time of production.

As a material for the third metal oxide layer in the present invention, the same ones as mentioned as the material for the second metal oxide layer may be mentioned. And, the material for the third metal oxide layer is preferably the same as the material for the second metal oxide layer from the viewpoint of easiness of manufacturing. The thickness of the third metal oxide layer is preferably from 1 to 60 nm, more preferably from 2 to 30 nm, further preferably from 2 to 15 nm.

(Production Process of Electroconductive Laminate)

The forming method of the electroconductive film formed on the substrate surface may, for example, be a sputtering method, a vacuum deposition method, an ion plating method or a chemical vapor deposition method, and is preferably a sputtering method from the viewpoint that the quality and the stability of the properties are good.

As the sputtering method, DC sputtering method, pulse sputtering method or AC sputtering method may be mentioned.

The electroconductive laminate of the present invention may be produced by, for example, the following process:

A process for producing an electroconductive laminate, which comprises repeating the following steps (1) to (3) n times (wherein n is an integer of from 1 to 6); and then forming a first metal oxide layer as the outermost layer by carrying out the following step (1):

(1) a step of forming a first metal oxide layer on one surface of a substrate by a sputtering method using a target containing titanium element and an M element (wherein the M element is at least one element selected from the group consisting of elements having atomic weights of at least 80);

(2) a step of forming a second metal oxide layer by a sputtering method using a target containing zinc element;

(3) a step of forming a metal layer by a sputtering method using a target containing silver as its main component.

In the above step (1), it is preferred that sputtering is carried out by using a metal target as the target while a gas containing an oxygen gas is introduced. Further, at this time, it is preferred that sputtering is carried out while e.g. flow rate of the sputtering gas is controlled in order to maintain the transition region. The transition region is a region where a target transits from a state of metal to a state of an oxide. Particularly, it is preferred to carry out a method i.e. plasma emission monitor (PEM) control sputtering, wherein sputtering is carried out while the target is maintained within the transition region by monitoring the emission intensity of plasma generated from the target with a sensor to monitor the state of the target and by feeding back it to control the flow rate of the sputtering gas. A sputtering within the transition region is preferred because the film forming rate can be more increased.

Further, in the above steps (1) and (2), in the case of using an oxide target as the target, the production process of the electroconductive laminate may be, for example, the process comprising:

(i) carrying out DC sputtering using an oxide target containing titanium element and the M element while introducing an argon gas mixed with an oxygen gas to form a first mefal oxide layer on the surface of a substrate;

(ii) carrying out DC sputtering using a target having, as the main component, an oxide of zinc while introducing an argon gas mixed with an oxygen gas to form a second metal oxide layer on the surface of the first metal oxide layer; and

(iii) carrying out DC sputtering using a silver target or a silver alloy target while introducing an argon gas or a nitrogen gas to form a metal layer on the surface of the second metal oxide layer.

The above operations (i) to (iii) are repeated for n times (n is an integer of from 1 to 6), and lastly another first metal oxide layer is formed by the same method as (i), to form an electroconductive film of a multilayered structure on a substrate surface to produce an electroconductive laminate.

By the above process, an electroconductive laminate having an electroconductive film on a substrate surface, which electroconductive film has laminated n lamination units (wherein n is an integer of from 1 to 6) each having a first metal oxide layer, a second metal oxide layer and a metal layer arranged in this order from the substrate side, and further has a first metal oxide layer disposed as the outermost layer of the electroconductive film is produced.

When a lamination unit in the electroconductive laminate produced by the above production process further has a third metal oxide layer at the side of the metal layer opposite to the substrate, such an electroconductive laminate may be produced by the following process:

A process for producing an electroconductive laminate, which comprises repeating the following steps (1) to (4) n times (wherein n is an integer of from 1 to 6); and then forming a first metal oxide layer as the outermost layer by carrying out the following step (1):

(1) a step of forming a first metal oxide layer on one surface of a substrate by a sputtering method using a target containing titanium element and an M element (wherein the M element is at least one element selected from the group consisting of elements having atomic weights of at least 80);

(2) a step of forming a second metal oxide layer by a sputtering method using a target containing zinc element;

(3) a step of forming a metal layer by a sputtering method using a target containing silver as its main component;

(4) a step of forming a third metal oxide layer by a sputtering method using a target containing zinc element.

In the above step (1), it is preferred that sputtering is carried out by using a metal target as the target while a gas containing an oxygen gas is introduced. Further, at this time, it is preferred that sputtering is carried out while e.g. flow rate of the sputtering gas is controlled in order to maintain the transition region. Particularly, it is preferred to carry out a plasma emission monitor (PEM) control sputtering. A sputtering within the transition region is preferred because the film forming rate can be more increased.

Further, in the above steps (1), (2) and (4), in the case of using an oxide target as the target, the production process of the electroconductive laminate may be, for example, the process comprising:

(i) carrying out DC sputtering using an oxide target containing titanium element and the M element while introducing an argon gas mixed with an oxygen gas to form a first metal oxide layer on the surface of a substrate;

(ii) carrying out DC sputtering using a target having an oxide of zinc as the main component while introducing an argon gas mixed with an oxygen gas to form a second metal oxide layer on the surface of the first metal oxide layer;

(iii) carrying out DC sputtering using a silver target or a silver alloy target while introducing an argon gas or a nitrogen gas to form a metal layer on the surface of the second metal oxide layer; and

(iv) carrying out DC sputtering using a target having an oxide of zinc as the main component while introducing an argon gas mixed with a small amount of an oxygen gas to form a third metal oxide layer on the surface of the metal layer.

The above operations (i) to (iv) are repeated for n times, and lastly another first metal oxide layer is formed by the same method as (i), to form an electroconductive film of a multilayered structure on a substrate surface to produce an electroconductive laminate.

The gas pressure at the time of sputtering is preferably at most 0.40 Pa, and the lower limit is preferably 0.01 Pa, in any of the above steps.

The electric power density is, in the case of forming respective metal oxide layers, preferably from 2.5 to 5.0 W/cm$^2$, more preferably from 3.0 to 4.0 W/cm$^2$, and in the case of forming a metal layer, it is preferably from 0.3 to 0.8 W/cm$^2$, more preferably from 0.4 to 0.6 W/cm$^2$.

The gas composition introduced at the time of sputtering for the formation of a metal oxide layer preferably consists essentially of an oxygen gas and an inert gas in both cases where a metal target is used as the target and where an oxide target is used as the target. In the formation of a metal oxide layer, the sputter yield on the target surface depends on the flow rate of the oxygen gas and the inert gas. Accordingly, the film forming rate to a material also changes. It is preferred that the flow rate of the inert gas and the flow rate of the oxygen gas introduced at the time of sputtering in the formation of a metal oxide layer are adjusted so that the film forming rate will be 3.2 to 8.1 times as rapid as the film forming rate of when a metal target is used and only an oxygen gas is introduced.

The inert gas introduced at the time of sputtering may, for example, be an argon gas, a neon gas, a krypton gas or a xenon gas.

The oxide target may be prepared by mixing respective high-pure (usually 99.9%) powders of an oxide only of each metal and sintering them by hot press method, HIP (hot isostatic press) method or atmospheric sintering method.

In the case where the first metal oxide layer, the second metal oxide layer and the third metal oxide layer are formed by using an oxide target, the composition ratio of respective metal elements in each metal oxide layer is almost the same as the composition ratio of respective metal elements of the oxide target.

(Electroconductive Laminate)

The sheet resistance of the electroconductive laminate of the present invention is preferably from 0.1 to 3.5 Ω/□, more preferably from 0.3 to 2.5 Ω/□, particularly preferably from 0.3 to 1.0 Ω/□, with a view to sufficiently securing the electrical conductivity (electromagnetic wave shielding properties).

In the electroconductive laminate of the present invention, the first metal oxide layer and the second metal oxide layer in a lamination unit are preferably laminated directly in contact with each other. The first metal oxide layer and the second metal oxide layer are directly in contact with each other, whereby the second metal oxide layer is laminated directly on the surface of the first metal oxide layer, which surface is flat, and thus the surface of the second metal oxide layer may also be made more flat. Further, the second metal oxide layer and the metal layer are laminated directly in contact with each other, whereby the metal layer may also be a layer having a flat surface. Further, the second metal oxide layer is a layer having, as the main component, zinc oxide having a crystal structure close to silver, whereby a film which is physically flat and which has good crystal properties may be obtained, and thus it is possible to reduce the resistance of the metal layer. Further, the first metal oxide layer contains titanium element and thereby has a high refractive index, and thus the reflected color of the laminate may be closer to neutral (achromatic color).

Further, the resistance of the metal layer (silver layer) in the present invention is low, whereby a sufficient sheet resistance value may be obtained even when the film thickness of the metal layer is made thin. Thus, while the sheet resistance value is maintained low to some extent, the visible light transmittance of the entire electroconductive laminate can be made low with a thin silver layer. Therefore, the electroconductive laminate of the present invention has an effect such that both excellent electrical conductivity and excellent visible light transmitting properties are provided.

Further, the electroconductive laminate of the present invention may have a protective film on the outermost surface of the electroconductive film i.e. the surface of the first metal oxide layer farthest from the substrate. The protective film protects the first, the second and the third metal oxide layers and the metal layer from water.

The protective film may, for example, be an oxide film or a nitride film of tin, indium, titanium, silicon, gallium or the like, or a hydrogenated carbon film, and it is preferably a film containing, as the main component, an oxide of at least one metal selected from the group consisting of indium, gallium and tin, or a hydrogenated carbon film.

The film thickness of the protective film is preferably from 2 to 30 nm, more preferably from 3 to 20 nm. Further, the protective film may be a single layer film only of one type of the above protective films, or it may be a multilayer film having two or more types of the films laminated.

Further, the electroconductive laminate of the present invention may have a resin film laminated on the surface of the first metal oxide layer farthest from the substrate or on the surface of the above protective film, via an adhesive. The resin film may, for example, be a moisture-proof film, an antiscattering film, an antireflection film, a protective film for e.g. near-infrared shielding or a functional film such as a near-infrared absorbing film. The resin film is laminated, whereby it is possible to protect the electroconductive film in the present invention from e.g. moisture.

The electroconductive laminate of the present invention has an excellent electrical conductivity (electromagnetic wave shielding properties) and a high visible light transmittance, and further when it is laminated on a supporting substrate of e.g. glass, the transmission/reflection band becomes broad, and thus the electroconductive laminate of the present invention is useful as an electromagnetic wave shielding film for a plasma display.

Further, the electroconductive laminate of the present invention may be used as a transparent electrode of e.g. liquid crystal display devices. The transparent electrode has a low sheet resistance and thus has a good responsibility, and it may have the reflectance suppressed at a low level and thus has a good visibility.

Further, the electroconductive laminate of the present invention may be used as a windshield glass for automobiles. The windshield glass for automobiles may provide a function of antifogging or melting of ice by applying current to the electroconductive film, while it requires a low voltage to apply current because of the low resistance, and further it may have the reflectance suppressed at a low level, and thus the visibility of a driver is not declined.

Further, the electroconductive laminate of the present invention may be used as a heat mirror which is provided on windows of buildings because it has extremely high reflectance in the infra-red region.

Further, since the electroconductive laminate of the present invention has a high electromagnetic wave shielding effect, it may be used as an electromagnetic wave shielding window glass which prevents electromagnetic waves radiated from electrical and electronic equipments from escaping to outside of a room and which prevents electromagnetic waves affecting electrical and electronic equipments from intruding from outside to inside of a room.

<Protective Plate for Plasma Display>

The protective plate for a plasma display of the present invention (hereinafter referred to as a protective plate) comprises a supporting substrate and an electroconductive laminate of the present invention provided on the supporting substrate.

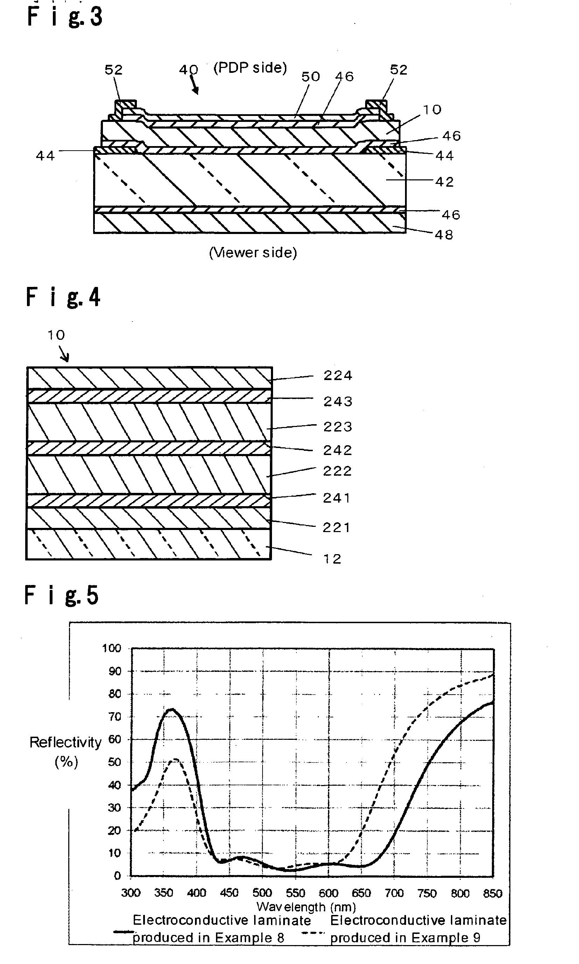

An example of the protective plate of the present invention is illustrated in Fig. 3. The protective plate 40 has a supporting substrate 42; a colored ceramic layer 44 provided at the edge portion of the supporting substrate 42; an electroconductive laminate 10 bonded to the surface of the supporting substrate 42 via an adhesive layer 46 so that the edge portion of the electroconductive laminated 10 overlaps with the colored ceramic layer 44; an antiscattering film 48 bonded to the surface of the supporting substrate 42 at the side opposite to the electroconductive laminate 10 via an adhesive layer 46; a protective film 50 bonded to the surface of the electroconductive laminate 10 via an adhesive layer 46; and an electrode 52 which is provided at the edge portion of the electroconductive laminate 10 and the protective film 50 and which is electrically connected to electroconductive film 14 of the electroconductive laminate 10 by direct contact. The protective plate 40 is an example wherein the electroconductive laminate 10 is provided at the PDP side of the supporting substrate 42.

The supporting substrate 42 is a transparent substrate having a higher rigidity than substrate 12 of the electroconductive laminate 10. The supporting substrate 42 is provided, whereby warpage is not caused by temperature difference made between the PDP side and the viewer side even when the material of the substrate 12 of the electroconductive laminate 10 is a plastic such as PET. The material of the supporting substrate 42 may be the same material as the above substrate 12, and is preferably glass. When the substrate 12 is made of a material having rigidity such as glass, the substrate 12 has a supporting function, and thus it is not required to provide a supporting substrate 42.

The colored ceramic layer 44 is a layer to hide the electrode 52 so that the electrode 52 cannot be seen from the viewer side. The colored ceramic layer 44 may be formed by, for example, printing on the supporting substrate 42 or taping with a colored tape.

The antiscattering film 48 is a film to prevent broken pieces of the supporting substrate 42 from flying at the time of damage of the supporting substrate 42. As the antiscattering film 48, known ones may be used.

The antiscattering film 48 may have an antireflection function. A film having both antiscattering function and antireflection function may, for example, be a film having a layer of a fluororesin such as a fluoroacrylic resin provided on a surface of a substrate made of a resin such as PET, and specifically, ARCTOP (product name) manufactured by Asahi Glass Company, Limited or ReaLook (product name) manufactured by NOF Corporation may be mentioned. Further, a film having an antireflection layer having a low refractive index formed by a dry process on a film made of a polymer such as PET, or the like may also be mentioned.

The electrode 52 is provided to be electrically connected to the electroconductive film 14 so that the electromagnetic wave shielding effect of the electroconductive laminate 10 by having the electroconductive film 14 may be provided. For such an electrical connection, for example, the electrode 52 and the electroconductive film 14 are disposed to be directly in contact with each other. The electrode 52 is preferably provided around the whole edge portion of the electroconductive laminate 10 with a view to securing the electromagnetic wave shielding effect by the electroconductive film 14.

As to the material of the electrode 52, one having a lower resistance has an advantage in electromagnetic wave shielding properties. The electrode 52 is formed by, for example, applying and firing an silver paste containing silver and a fritted glass or a copper paste containing copper and a fritted glass.

The protective film 50 is a film protecting the electroconductive laminate 10 (electroconductive film 14). In the case of protecting the electroconductive film 14 from water, a moisture-proof film is provided. The moisture-proof film may, for example, be a film made of a plastic such as PET or polyvinylidene chloride. Further, as the protective film 50, the above-mentioned antiscattering film may also be used.

As the adhesive of the adhesive layers 46, a commercial adhesive may be mentioned. It may, for example, be an adhesive made of e.g. an acrylic acid ester copolymer, polyvinyl chloride, an epoxy resin, a polyurethane, a vinyl acetate copolymer, a styrene/acrylic copolymer, a polyester, a polyamide, a polyolefin, a styrene/butadiene copolymer rubber, a butyl rubber or a silicone resin. Among them, an acrylic adhesive is particularly preferred because a good moisture resistance may thereby be obtained. In the adhesive layers 46, additives such as an ultraviolet absorbing agent may be incorporated.

The protective plate 40 is placed in front of a PDP, and thus the luminous transmittance is preferably at least 35% so that graphics on the PDP will not be less visible. Further, the luminous reflectance is preferably less than 6%, particularly preferably less than 3%. Further, the transmittance at a wavelength of 850 nm is preferably at most 5%, particularly preferably at most 2%.

The protective plate 40 as described above has an excellent electrical conductivity (electromagnetic wave shielding properties) and a high visible light transmittance, and since it uses the electroconductive laminate 10 which is excellent in fingerprint corrosion resistance, it has excellent electromagnetic wave shielding properties and a broad transmission/reflection band and is excellent in fingerprint corrosion resistance.

The protective plate of the present invention is not limited to the above embodiments. For example, bonding by heat may be carried out without providing an adhesive layer 46.

Further, as to the protective plate of the present invention, an antireflection layer which is an antireflection film or a thin film having a low refractive index may be provided, as the case requires.

As the antireflection film, a publicly known one may be used, and a fluororesin-type film is particularly preferred from the viewpoint of antireflection properties.

The antireflection layer is preferably one having a wavelength with which the reflectance becomes the lowest in the visible light region of from 500 to 600 nm, particularly preferably one having such a wavelength of from 530 to 590 nm, because the reflectance of the protective plate is thereby reduced, and a preferred reflected color may be obtained.

Further, the protective plate may have an infrared shielding function. The method to provide the infrared shielding function may, for example, be a method using an infrared shielding film, a method using an infrared absorbing substrate, a method using an adhesive having an infrared absorbing agent incorporated at the time of film lamination, a method of adding an infrared absorbing agent to e.g. an antireflection film to provide the infrared absorbing function or a method using an electroconductive film having an infrared reflecting function.

EXAMPLES

Now, the present invention will be described more detail with reference to Examples. It should be understood, however, that the present invention is by no means limited to these Examples.

Examples 1 to 5 are experimental examples where the surface flatness of the first metal oxide layer and the temperature increase at the substrate surface at the time of sputtering were measured. Examples 6 and 8 are working examples, and Examples 7 and 9 are comparative examples.

(Luminous Transmittance)

The luminous transmittance of the electroconductive laminate was measured by using a transmittance measuring instrument (MODEL 304 manufactured by Asahi Spectra Co., Ltd.).

(Sheet Resistance)

The sheet resistance of the electroconductive laminate was measured by using an eddy-current type resistance measuring instrument (717 Conductance Monitor manufactured by DELCOM).

(Surface Flatness)

Measurement of the surface roughness (arithmetic surface roughness Ra) was carried out by using an atomic force microscope (AFM) (device name: SP13800/SPA400 manufactured by Seiko Instruments Inc.).

(Temperature Increase at Glass Substrate Surface)

A thermocouple connected to a digital recorder (product name: GR-3500 manufactured by KEYENCE CORPORATION) was fit on a glass substrate surface, and the glass substrate was placed in a sputtering chamber. The temperature at the glass substrate surface was measured while sputtering was carried out. The temperature increase at the glass substrate surface was obtained by the following formula:

$$\text{(The highest value of the surface temperature of the glass substrate during sputtering)} - \text{(the temperature at the glass substrate surface before sputtering)} = \text{(temperature increase at the glass substrate surface)}$$

EXAMPLE 1

EXAMPLE 1-1

A glass substrate subjected to dry scrub treatment was prepared.

While a mixed gas composed of 99.22 vol% of argon gas and 0.78 vol% of oxygen gas was introduced, DC sputtering was carried out by using an oxide target containing titanium element and niobium element (an oxide target having 80 atom% of Ti element and 20 atom% of Nb element in the total of Nb element and Ti element) under a condition of a pressure of 0.04 Pa and an electric power density of 1.43 $W/cm^2$ to form a metal oxide layer containing titanium element and niobium element having a thickness of 40 nm on the surface of the glass substrate. In the oxide layer containing titanium element and niobium element, the total content of niobium element and titanium element in the total amount of metal elements was at least 98 atom%, and the content of niobium element in the total amount of titanium element and niobium element was 20 atom%. Further, the film forming rate of the oxide layer containing titanium element and niobium element was 2.4 nm m/min.

The surface flatness of the single film of the obtained oxide layer containing titanium element and niobium element was measured. The result is shown in Table 1.

EXAMPLE 1-2

Sputtering was carried out under the same condition as in Example 1-1 except that the temperature at the glass substrate surface was measured. The temperature increase at the glass substrate surface during sputtering was 15.1°C. The result is shown in Table 2.

EXAMPLE 2

EXAMPLE 2-1

A glass substrate subjected to dry scrub treatment was prepared.

While a mixed gas composed of 83.3 vol% of argon gas and 16.7 vol% of oxygen gas was introduced, DC sputtering was carried out by using a titanium target (titanium purity: 99.99%) under a condition of a pressure of 0.11 Pa and an electric power density of 2.14 $W/cm^2$ to form a titanium oxide layer having a thickness of 40 nm on the surface of the glass substrate. The content of titanium element in the total amount of metal elements in the titanium oxide layer was at least 98 atom%. The film forming rate of the titanium oxide layer was 0.36 nm m/min.

The surface flatness of the single film of the obtained titanium oxide layer was measured. The result is shown in Table 1.

EXAMPLE 2-2

Sputtering was carried out under the same condition as in Example 2-1 except that the temperature at the glass substrate surface was measured, the mixed gas was composed of 86.7 vol% of argon gas and 13.3 vol% of oxygen gas, the pressure was 0.09 Pa and the electric power density was 1.43 $W/cm^2$. The temperature increase at the glass substrate surface during sputtering was 7.97°C. The result is shown in Table 2.

EXAMPLE 3

EXAMPLE 3-1

A glass substrate subjected to dry scrub treatment was prepared.

While a mixed gas composed of 83.3 vol% of argon gas and 16.7 vol% of oxygen gas was introduced, DC sputtering was carried out by using a metal target containing titanium element and zirconium element (a metal target having 85 atom% of Ti element and 15 atom% of Zr element in the total of Zr element and Ti element) under a condition of a pressure of 0.08 Pa and an electric power density of 2.14 W/cm$^2$ to form a metal oxide layer containing titanium element and zirconium element having a thickness of 40 nm on the surface of the glass substrate. In the oxide layer containing titanium element and zirconium element, the total content of zirconium element and titanium element in the total amount of metal elements was at least 98 atom%, and the content of zirconium element in the total amount of titanium element and zirconium element was 15 atom%. Further, the film forming rate of the oxide layer containing titanium element and zirconium element was 0.73 nm m/min.

The surface flatness of the single film of the obtained oxide layer containing titanium element and zirconium element was measured. The result is shown in Table 1.

EXAMPLE 3-2

Sputtering was carried out under the same condition as in Example 3-1 except that the temperature at the glass substrate surface was measured, the mixed gas was composed of 90 vol% of argon gas and 10 vol% of oxygen gas, the pressure was 0.07 Pa and the electric power density was 1.43 W/cm$^2$. The temperature increase at the glass substrate surface during sputtering was 9.27°C. The result is shown in Table 2.

TABLE 1

|  | Metal oxide layer | Ra (nm) | Film forming rate (nm·m/min) |
|---|---|---|---|
| Ex. 1-1 | Ti-Nb | 0.226 | 2.4 |
| Ex. 2-1 | Ti | 0.302 | 0.36 |
| Ex. 3-1 | Ti-Zr | 0.236 | 0.73 |

TABLE 2

|  | Metal oxide layer | Temperature increase at glass substrate surface (°C) |
|---|---|---|
| Ex. 1-2 | Ti-Nb | 15.1 |
| Ex. 2-2 | Ti | 7.97 |
| Ex. 3-2 | Ti-Zr | 9.27 |

The metal oxide layers in Tables 1 and 2 are the following ones.

Ti: Titanium oxide layer
Ti-Nb: Oxide layer containing titanium element and niobium element
Ti-Zr: Oxide layer containing titanium element and zirconium element

The results of Examples 1-1 and 1-2 show that the film forming rate of the oxide layer containing titanium element and niobium element, which employs niobium element as the M element, was very rapid, but the temperature increase at the substrate surface was large. Further, the value of surface roughness of the oxide layer containing titanium element and niobium element was small, and the surface was flat.

Further, the result of Example 3-1 shows that the film forming rate of the oxide layer containing titanium element and zirconium element, which employs zirconium element as the M element, was about twice as rapid as the film forming rate of the titanium oxide layer in Example 2-1.

EXAMPLE 4

EXAMPLE 4-1

A glass substrate subjected to dry scrub treatment was prepared.

While a mixed gas composed of 95.85 vol% of argon gas and 4.15 vol% of oxygen gas was introduced, DC sputtering was carried out by using a titanium target (titanium purity: 99.99%) under a condition of a pressure of 0.1 Pa and an electric power density of 1.43 $W/cm^2$ to form a metal oxide layer containing titanium element having a thickness of 40 nm on the surface of the glass substrate. Sputtering was carried out while the flow rate of the sputtering gas was controlled (PEM control) to maintain the target within the transition region by monitoring the emission intensity of the plasma generated from the target to monitor the state of the target and by feeding back it, to form a titanium oxide layer. The content of titanium element in the total amount of metal elements in the titanium oxide layer was at least 98 atom%. The film forming rate of the titanium oxide layer was 2.08 nm·m/min.

The surface flatness of the single film of the obtained titanium oxide layer was measured. The result is shown in Table 3.

EXAMPLE 4-2

Sputtering was carried out under the same condition as in Example 4-1 except that the temperature at the glass substrate surface was measured. The temperature increase at the glass substrate surface at the time of sputtering was 11.2°C. The result is shown in Table 4.

EXAMPLE 5

EXAMPLE 5-1

A glass substrate subjected to dry scrub treatment was prepared.

While a mixed gas composed of 95.24 vol% of argon gas and 4.76 vol% of oxygen gas was introduced, DC sputtering was carried out by using a metal target containing titanium element and zirconium element (a metal target having 85 atom% of Ti element and 15 atom% of Zr element in the total of Zr element and Ti element) under a condition of a pressure of 0.09 Pa and an electric power density of 1.43 $W/cm^2$ to form a metal oxide layer containing titanium element and zirconium element having a thickness of 40 nm on the surface of the glass substrate. Sputtering was carried out while the target was maintained within the transition region by PEM control. In the metal oxide layer containing titanium element and zirconium element, the total content of zirconium element and titanium element in the total amount of metal elements was at least 98 atom%, and the content of zirconium element in the total amount of titanium element and zirconium element was 15 atom%. Further, the film forming rate of the oxide layer containing titanium element and zirconium element was 3.07 nm·m/min.

The surface flatness of the single film of the obtained oxide layer containing titanium element and zirconium element was measured. The result is shown in Table 3.

EXAMPLE 5-2

Sputtering was carried out under the same condition as in Example 5-1 except that the temperature at the glass substrate surface was measured. The temperature increase at the glass substrate surface at the time of sputtering was 8.73°C. The result is shown in Table 4

TABLE 3

|  | Metal oxide layer | Ra (nm) | Film forming rate (nm·m/min) |
|---|---|---|---|
| Ex. 4-1 | Ti | 0.3022 | 2.08 |
| Ex. 5-1 | Ti-Zr | 0.2362 | 3.07 |

TABLE 4

|  | Metal oxide layer | Temperature increase at glass substrate surface (°C) |
|---|---|---|
| Ex. 4-2 | Ti | 11.2 |

(continued)

|  | Metal oxide layer | Temperature increase at glass substrate surface (°C) |
|---|---|---|
| Ex. 5-2 | Ti-Zr | 8.73 |

The metal oxide layers in Tables 3 and 4 are the following ones.

Ti: Titanium oxide layer
Ti-Zr: Oxide layer containing titanium element and zirconium element

The results in Examples 4-1 and 5-1 show that in the case where a metal oxide layer was formed by sputtering with PEM control by using a metal target, when zirconium element was used as the M element, the surface roughness (Ra) was reduced and the film forming rate was increased as compared with the case of the oxide only of titanium.

Further, the results in Examples 4-2 and 5-2 show that when zirconium element was used as the M element, the temperature increase at the glass substrate surface at the time of sputtering was able to be suppressed to a lower temperature by about 2.5°C as compared with the case of an oxide only of titanium.

EXAMPLE 6

An electroconductive laminate 10 illustrated in Fig. 2 was produced as follows.

A glass substrate subjected to dry scrub treatment was prepared.

(i) While a mixed gas composed of 99.22 vol% of argon gas and 0.78 vol% of oxygen gas was introduced, DC sputtering was carried out by using an oxide target containing titanium element and niobium element (an oxide target having 80 atom% of Ti element and 20 atom% of Nb element in the total of Nb element and Ti element) under a condition of a pressure of 0.04 Pa and an electric power density of 1.43 W/cm$^2$ to form an oxide layer (first metal oxide layer 211) containing titanium element and niobium element having a thickness of 20 nm on the surface of the glass substrate. In the first metal oxide layer 211, the total content of niobium element and titanium element in the total amount of metal elements was at least 98 atom%, and the content of niobium element in the total amount of titanium element and niobium element was 20 atom%. This layer had a refractive index of 2.45.

(ii) While a mixed gas composed of 97.2 vol% of argon gas and 2.8 vol% of oxygen gas was introduced, DC sputtering was carried out by using an oxide target containing zinc element and titanium element (a target containing 10 mass% of Ti as converted to $TiO_2$ and 90 mass% of Zn as converted to ZnO) under a condition of a pressure of 0.053 Pa and an electric power density of 3.57 W/cm$^2$ to form an oxide layer (second metal oxide layer 221) containing zinc element and titanium element having a thickness of 11 nm on the surface of the first metal oxide layer 211. The total content of titanium element and zinc element in the total amount of metal elements in the second metal oxide layer 221 was at least 98 atom%.

(iii) While an argon gas was introudced, DC sputtering was carried out by using a silver alloy target having silver doped with 0.5 atom% of gold under a condition of a pressure of 0.35 Pa and an electric power density of 0.5 W/cm$^2$ to form a metal layer 241 having a thickness of 14.5 nm on the surface of the second metal oxide layer 221. The silver content in the metal layer 241 was 99.5 atom%, and the gold content was 0.5 atom%.

(iv) While a mixed gas composed of 99 vol% of argon gas and 1 vol% of oxygen gas was introduced, DC sputtering was carried out by using an oxide target containing zinc oxide and titanium oxide (a target containing 10 mass% of Ti as converted to $TiO_2$ and 90 mass% of Zn as converted to ZnO) under a condition of a pressure of 0.15 Pa and an electric power density of 2.14 W/cm$^2$ to form a third metal oxide layer 231 having a thickness of 11 nm on the surface of the metal layer 241. The content of titanium element and zinc element in the total amount of metal elements in the third metal oxide layer 231 was 98 atom%.

The operations of (i) to (iv) were repeated two more times. In the second and third operations of (i), the thickness of the first metal oxide layer was 40 nm both in the second and the third operations, and in the operation of (iii), the thickness of the metal layer was 16.5 nm in the second operation and 14.5 nm in the third operation.

Lastly, the operation of (i) was carried out to obtain an electroconductive laminate.

The luminous transmittance of the electroconductive laminate was 72.3%, and the sheet resistance at the surface of the electroconductive film of the electroconductive laminate was 0.958 Ω/□. The results are shown in Table 5.

EXAMPLE 7

An electroconductive laminate 10 illustrated in Fig. 2 was produced as follows.

A glass substrate subjected to dry scrub treatment was prepared.

(i) While a mixed gas composed of 83.3 vol% of argon gas and 16.7 vol% of oxygen gas was introduced, DC sputtering was carried out by using a titanium target (titanium purity: 99.99%) under a condition of a pressure of 0.11 Pa and an electric power density of 2.14 W/cm$^2$ to form a titanium oxide layer (corresponding to the first metal oxide layer 211) having a thickness of 20 nm on the surface of the glass substrate. The content of titanium element in the total amount of metal elements in the titanium oxide layer was at least 98 atom%.

(ii) While a mixed gas composed of 97.2 vol% of argon gas and 2.8 vol% of oxygen gas was introduced, DC sputtering was carried out by using an oxide target containing zinc element and titanium element (a target containing 10 mass% of Ti as converted to $TiO_2$ and 90 mass% of Zn as converted to ZnO) under a condition of a pressure of 0.053 Pa and an electric power density of 3.57 W/cm$^2$ to form an oxide layer (corresponding to the second metal oxide layer 221) containing zinc element and titanium element having a thickness of 11 nm on the surface of the titanium oxide layer. The total content of titanium element and zinc element in the total amount of metal elements in the oxide layer containing zinc element and titanium element was at least 98 atom%.

(iii) While an argon gas was introduced, DC sputtering was carried out by using a silver alloy target having silver doped with 0.5 atom% of gold under a condition of a pressure of 0.35 Pa and an electric power density of 0.5 W/cm$^2$ to form a layer corresponding to the metal layer 241 having a thickness of 14.5 nm on the surface of the oxide layer containing zinc element and titanium element. The silver content in the metal layer was 99.5 atom%, and the gold content was 0.5 atom%.

(iv) While a mixed gas composed of 99 vol% of argon gas and 1 vol% of oxygen gas was introduced, DC sputtering was carried out by using an oxide target containing zinc oxide and titanium oxide (a target containing 10 mass% of Ti as converted to $TiO_2$ and 90 mass% of Zn as converted to ZnO) under a condition of a pressure of 0.15 Pa and an electric power density of 2.14 W/cm$^2$ to form an oxide layer containing zinc element and titanium element (corresponding to the third metal oxide layer 231) having a thickness of 11 nm on the surface of the metal layer. The content of titanium element and zinc element in the total amount of metal elements in the oxide layer containing zinc element and titanium element was 98 atom%.

The operations of (i) to (iv) were repeated two more times. In the second and third operations of (i), the thickness of the first metal oxide layer was 40 nm both in the second and the third operations, and in the operation of (iii), the thickness of the metal layer was 16.5 nm in the second operation and 14.5 nm in the third operation.

Lastly, the operation of (i) was carried out to obtain an electroconductive laminate.

The luminous transmittance of the electroconductive laminate was 56.5%, and the sheet resistance at the surface of the electroconductive film of the electroconductive laminate was 1.06 Ω/□. The results are shown in Table 5.

TABLE 5

| | First metal oxide layer | Luminous transmittance (%) | Resistance value (Ω/□) |
|---|---|---|---|
| Ex. 6 | Oxide layer containing titanium element and niobium element | 72.3 | 0.958 |
| Ex. 7 | Oxide layer containing titanium element | 56.5 | 1.06 |

In Examples 6 and 7, the respective thicknesses per one metal layer are the same. Generally there is a correlation between the thickness of a metal layer and the resistance value of an laminate, and when the thicknesses of metal layers are the same, the resistance values of the laminates are usually almost the same. However, in the present examples, the resistance value in Example 6 was lower by about 0.1, which was better result, as compared with Example 7. It is considered that the reason is that as compared with the case where the material of the first metal oxide layer is only titanium element, in the case where the material is titanium element and niobium element which further contains 13.1 atom% of niobium element, the crystal properties are largely collapsed, and the surface of the layer which is amorphous and smooth, i.e. the surface of the first metal oxide layer, is flat (Example 1). Therefore, it is presumed that the laminate in Example 6 had more flat surface of the metal layer and thereby had the resistance value reduced.

EXAMPLE 8

An electroconductive laminate 10 illustrated in Fig. 2 was produced as follows.

A glass substrate subjected to dry scrub treatment was prepared.

(i) While a mixed gas composed of 95.24 vol% of argon gas and 4.76 vol% of oxygen gas was introduced, DC sputtering was carried out by using an oxide target containing titanium element and zirconium element (an oxide target having 85 atom% of Ti element and 15 atom% of Zr element in the total of Zr element and Ti element) under a condition of a pressure of 0.09 Pa and an electric power density of 1.43 W/cm$^2$ to form a metal oxide layer (first metal oxide layer 211) containing titanium element and zirconium element having a thickness of 25 nm on the surface of the glass substrate. Sputtering was carried out while the target was maintained within the transition region by PEM control. In the first metal oxide layer 211, the total content of zirconium element and titanium element in the total amount of metal elements was at least 98 atom%, and the content of zirconium element in the total amount of titanium element and zirconium element was 15 atom%. This layer had a refractive index of 2.41.

(ii) While a mixed gas composed of 97.2 vol% of argon gas and 2.8 vol% of oxygen gas was introduced, DC sputtering was carried out by using an oxide target containing zinc element and titanium element (a target containing 10 mass% of Ti as converted to TiO$_2$ and 90 mass% of Zn as converted to ZnO) under a condition of a pressure of 0.053 Pa and an electric power density of 3.57 W/cm$^2$ to form an oxide layer (second metal oxide layer 221) containing zinc element and titanium element having a thickness of 11 nm on the surface of the first metal oxide layer 211. The total content of titanium element and zinc element in the total amount of metal elements in the second metal oxide layer 221 was at least 98 atom%.

(iii) While an argon gas was introduced, DC sputtering was carried out by using a silver alloy target having silver doped with 0.5 atom% of gold under a condition of a pressure of 0.35 Pa and an electric power density of 0.5 W/cm$^2$ to form a metal layer 241 having a thickness of 15.0 nm on the surface of the second metal oxide layer 221. The silver content in the metal layer 241 was 99.5 atom%, and the gold content was 0.5 atom%.

(iv) While a mixed gas composed of 99 vol% of argon gas and 1 vol% of oxygen gas was introduced, DC sputtering was carried out by using an oxide target containing zinc oxide and titanium oxide (a target containing 10 mass% of Ti as converted to TiO$_2$ and 90 mass% of Zn as converted to ZnO) under a condition of a pressure of 0.15 Pa and an electric power density of 2.14 W/cm$^2$ to form a third metal oxide layer 231 having a thickness of 11 nm on the surface of the metal layer 241. The content of titanium element and zinc element in the total amount of metal elements in the third metal oxide layer 231 was 98 atom%.

The operations of (i) to (iv) were repeated two more times. In the second and third operations of (i), the thickness of the first metal oxide layer was 51 nm both in the second and the third operations, and in the operation of (iii), the thickness of the metal layer was 15.5 nm in the second operation and 15.0 nm in the third operation.

Lastly, the operation of (i) was carried out to obtain an electroconductive laminate.

In Fig. 5, the solid line represents the spectral reflectivity of the obtained electroconductive laminate.

EXAMPLE 9

An electroconductive laminate 10 illustrated in Fig. 4 was produced as follows.

A glass substrate subjected to dry scrub treatment was prepared.

(i) While a mixed gas composed of 97.2 vol% of argon gas and 2.8 vol% of oxygen gas was introduced, DC sputtering was carried out by using an oxide target containing zinc element and titanium element (a target containing 10 mass% of Ti as converted to TiO$_2$ and 90 mass% of Zn as converted to ZnO) under a condition of a pressure of 0.053 Pa and an electric power density of 3.57 W/cm$^2$ to form an oxide layer (second metal oxide layer 221) containing zinc element and titanium element having a thickness of 39.5 nm on the surface of the glass substrate. The total content of titanium element and zinc element in the total amount of metal elements in the second metal oxide layer 221 was at least 98 atom%. This layer had a refractive index of 2.05.

(ii) While an argon gas was introduced, DC sputtering was carried out by using a silver alloy target having silver doped with 0.5 atom% of gold under a condition of a pressure of 0.35 Pa and an electric power density of 0.5 W/cm$^2$ to form a metal layer 241 having a thickness of 15.0 nm on the surface of the second metal oxide layer 221. The silver content in the metal layer 241 was 99.5 atom%, and the gold content was 0.5 atom%.

The operations of (i) and (ii) were repeated two more times. In the second and third operations of (i), the thickness of the first metal oxide layer was 79 nm both in the second and the third operations, and in the operation of (ii), the thickness of the metal layer was 15.5 nm in the second operation and 15 nm in the third operation. Lastly, the operation of (i) was carried out to obtain an electroconductive laminate.

In Fig. 5, the dashed line represents the spectral reflectivity of the obtained electroconductive laminate.

In Examples 8 and 9, the thicknesses of the metal layers are the same, but the reflection band in the spectral reflectivity is broader in Example 8, which is a working example of the present invention.

The reason is as follows: In the construction of Example 9, which is a comparative example, only the second metal oxide layer, which is formed by sputtering using a target containing zinc element as the main component, is formed as a metal oxide layer. In this construction, it is possible to form a metal oxide layer having high crystal properties by the effect of the second metal oxide layer, but on the other hand, the refractive index of the second metal oxide layer is smaller than the refractive index of the first metal oxide layer in Example 8, and thus the reflection band in the obtained spectral reflectivity is narrowed. By contrast, in Example 8, which is a working example of the present invention, a broad reflection band may be obtained by the effect of the refractive index of the first metal oxide layer while the characteristics of silver are maintained.

INDUSTRIAL APPLICABILITY

The electroconductive laminate of the present invention has an excellent electrical conductivity (electromagnetic wave shielding properties), a high visible light transmittance and an excellent fingerprint corrosion resistance, and further, when it is laminated on a supporting substrate, the transmission/reflection band becomes broad, and thus it is useful as a protective plate for a plasma display. Further, the electroconductive laminate of the present invention may be used as a transparent electrode of e.g. liquid crystal display devices, a windshield glass for automobiles, a heat mirror, an electromagnetic wave shielding window glass, and so on, and thus it is industrially useful.

The entire disclosure of Japanese Patent Application No. 2008-288891 filed on November 11, 2008 including specification, claims, drawings and summary is incorporated herein by reference in its entirety.

REFERENCE SYMBOLS

10: Electroconductive laminate
12: Substrate
14: Electroconductive film
211, 212, 213 and 214: First metal oxide layer
221, 222 and 223: Second metal oxide layer
231, 232 and 233: Third metal oxide layer
241, 242 and 243: Metal layer

**Claims**

1. An electroconductive laminate comprising a substrate and an electroconductive film formed on the substrate, wherein the electroconductive film has laminated n lamination units (wherein n is an integer of from 1 to 6) each having a first metal oxide layer, a second metal oxide layer and a metal layer arranged in this order from the substrate side, and further has a first metal oxide layer disposed as the outermost layer of the electroconductive film; the first metal oxide layer is an oxide layer containing titanium element and an M element, wherein the M element is at least one element selected from the group consisting of elements having atomic weights of at least 80, and the amount of the M element is from 10 to 60 atom% in the total amount of titanium element and the M element in the first metal oxide layer; the second metal oxide layer is a layer having, as its main component, an oxide containing zinc element; the metal layer is a layer having silver as its main component; and the second metal oxide layer and the metal layer in the lamination unit are directly in contact with each other.

2. An electroconductive laminate comprising a substrate and an electroconductive film formed on the substrate, wherein the electroconductive film has laminated n lamination units (wherein n is an integer of from 1 to 6) each having a first metal oxide layer, a second metal oxide layer and a metal layer arranged in this order from the substrate side, and further has a first metal oxide layer disposed as the outermost layer of the electroconductive film; the first metal oxide layer is an oxide layer containing titanium element and an M element, wherein the M element is niobium element, tantalum element, zirconium element or hafnium element, and the amount of the M element is from 10 to 60 atom% in the total amount of titanium element and the M element in the first metal oxide layer; the second metal oxide layer is a layer having, as its main component, an oxide containing zinc element; the metal layer is a layer having silver as its main component; and the second metal oxide layer and the metal layer in the lamination unit are directly in contact with each other.

3. The electroconductive laminate according to Claim 1 or 2, wherein the lamination unit further has a third metal oxide layer on the surface of the metal layer at the side opposite to the substrate, and the third metal oxide layer is a layer having, as its main component, an oxide containing zinc element.

4. The electroconductive laminate according to Claim 2 or 3, wherein the M element is zirconium element.

5. A protective plate for a plasma display, comprising a supporting substrate and an electroconductive laminate as defined in any one of Claims 1 to 4, provided on the supporting substrate.

6. A process for producing an electroconductive laminate, which comprises repeating the following steps (1) to (3) n times (wherein n is an integer of from 1 to 6); and then forming a first metal oxide layer as the outermost layer by carrying out the following step (1):

   (1) a step of forming a first metal oxide layer on one surface of a substrate by a sputtering method using a target containing titanium element and an M element (wherein the M element is at least one element selected from the group consisting of elements having atomic weights of at least 80);
   (2) a step of forming a second metal oxide layer by a sputtering method using a target containing zinc element;
   (3) a step of forming a metal layer by a sputtering method using a target containing silver as its main component.

7. A process for producing an electroconductive laminate, which comprises repeating the following steps (1) to (4) n times (wherein n is an integer of from 1 to 6); and then forming a first metal oxide layer as the outermost layer by carrying out the following step (1):

   (1) a step of forming a first metal oxide layer on one surface of a substrate by a sputtering method using a target containing titanium element and an M element (wherein the M element is at least one element selected from the group consisting of elements having atomic weights of at least 80);
   (2) a step of forming a second metal oxide layer by a sputtering method using a target containing zinc element;
   (3) a step of forming a metal layer by a sputtering method using a target containing silver as its main component;
   (4) a step of forming a third metal oxide layer by a sputtering method using a target containing zinc element.

8. A process for producing an electroconductive laminate, which comprises repeating the following steps (1) to (3) in total n times (wherein n is an integer of from 1 to 6); and then forming a first metal oxide layer as the outermost layer by carrying out the following step (1):

   (1) a step of forming a first metal oxide layer on one surface of a substrate by a sputtering method using a target containing titanium element and an M element (wherein the M element is niobium element, tantalum element, zirconium element or hafnium element);
   (2) a step of forming a second metal oxide layer by a sputtering method using a target containing zinc element;
   (3) a step of forming a metal layer by a sputtering method using a target containing silver as its main component.

9. A process for producing an electroconductive laminate, which comprises repeating the following steps (1) to (4) in total n times (wherein n is an integer of from 1 to 6); and then forming a first metal oxide layer as the outermost layer by carrying out the following step (1):

   (1) a step of forming a first metal oxide layer on one surface of a substrate by a sputtering method using a target containing titanium element and an M element (wherein the M element is niobium element, tantalum element, zirconium element or hafnium element);
   (2) a step of forming a second metal oxide layer by a sputtering method using a target containing zinc element;
   (3) a step of forming a metal layer by a sputtering method using a target containing silver as its main component;
   (4) a step of forming a third metal oxide layer by a sputtering method using a target containing zinc element.

# F i g. 1

# F i g. 2

20

# Fig.3

# Fig.4

# Fig.5

| INTERNATIONAL SEARCH REPORT | International application No. |
|---|---|
| | PCT/JP2009/069131 |

A.   CLASSIFICATION OF SUBJECT MATTER
*B32B9/00*(2006.01)i, *B32B7/02*(2006.01)i, *B32B15/04*(2006.01)i, *G09F9/00*
(2006.01)i, *H05K9/00*(2006.01)i

According to International Patent Classification (IPC) or to both national classification and IPC

B.   FIELDS SEARCHED

Minimum documentation searched (classification system followed by classification symbols)
B32B1/00-43/00, G09F9/00, H05K9/00

Documentation searched other than minimum documentation to the extent that such documents are included in the fields searched

| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| Y | WO 2006/090798 A1 (Asahi Glass Co., Ltd.), 31 August 2006 (31.08.2006), claims; paragraphs [0012], [0016], [0019] to [0021], [0028], [0029], [0033] & US 2008/0057264 A1 claims; paragraphs [0021], [0029], [0037] to [0040], [0048] to [0050], [0055] & EP 1860930 A1      & KR 10-2007-0111493 A & CN 101124863 A | 1-9 |

| ☒ | Further documents are listed in the continuation of Box C. | ☐ | See patent family annex. |
|---|---|---|---|

\* Special categories of cited documents:

"A"   document defining the general state of the art which is not considered to be of particular relevance

"E"   earlier application or patent but published on or after the international filing date

"L"   document which may throw doubts on priority claim(s) or which is cited to establish the publication date of another citation or other special reason (as specified)

"O"   document referring to an oral disclosure, use, exhibition or other means

"P"   document published prior to the international filing date but later than the priority date claimed

"T"   later document published after the international filing date or priority date and not in conflict with the application but cited to understand the principle or theory underlying the invention

"X"   document of particular relevance; the claimed invention cannot be considered novel or cannot be considered to involve an inventive step when the document is taken alone

"Y"   document of particular relevance; the claimed invention cannot be considered to involve an inventive step when the document is combined with one or more other such documents, such combination being obvious to a person skilled in the art

"&"   document member of the same patent family

| Date of the actual completion of the international search | Date of mailing of the international search report |
|---|---|
| 12 January, 2010 (12.01.10) | 26 January, 2010 (26.01.10) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.

PCT/JP2009/069131

C (Continuation).   DOCUMENTS CONSIDERED TO BE RELEVANT

| Category* | Citation of document, with indication, where appropriate, of the relevant passages | Relevant to claim No. |
|---|---|---|
| Y | WO 2007/007622 A1  (Asahi Glass Co., Ltd.), 18 January 2007 (18.01.2007), claims 1, 9 to 13; paragraphs [0007], [0008], [0011] to [0014], [0020] & EP 1909552 A1 claims 1, 9 to 13; paragraphs [0013] to [0017], [0020] to [0027], [0037] & KR 10-2008-0025367 A   & CN 101213895 A | 1-9 |
| Y | JP 2005-256087 A  (Nippon Sheet Glass Co., Ltd.), 22 September 2005 (22.09.2005), claims; paragraphs [0002], [0021], [0023], [0024], [0027] (Family: none) | 1-9 |
| Y | WO 2006/088108 A1  (Asahi Glass Co., Ltd.), 24 August 2006 (24.08.2006), claims; paragraphs [0008], [0015], [0016], [0078]; examples & US 2007/0298265 A1 claims; paragraphs [0015] to [0017], [0031], [0033], [0149] & EP 1849594 A1           & KR 10-2007-0111488 A & CN 101119842 A | 1-9 |
| Y | JP 11-157881 A  (Central Glass Co., Ltd.), 15 June 1999 (15.06.1999), claims 1 to 3; paragraphs [0013], [0014], [0045] (Family: none) | 1-9 |

Form PCT/ISA/210 (continuation of second sheet) (April 2007)

**EP 2 347 895 A1**

REFERENCES CITED IN THE DESCRIPTION

**Patent documents cited in the description**

- WO 200520655 A
- JP 2000246831 A
- JP 2000294980 A
- JP 2002277630 A
- JP 2008288891 A